# EUROPÄISCHE PATENTSCHRIFT

(11) **EP 3 221 263 B1**
(45) Veröffentlichungstag und Bekanntmachung des Hinweises auf die Patenterteilung: **19.09.2018**
(21) Anmeldenummer: 15795134.4
(22) Anmeldetag: 06.11.2015
(51) Int. Cl.: C01B 33/035, C23C 16/458, C23C 16/24, C23C 16/44

(54) **VORRICHTUNG ZUR ISOLIERUNG UND ABDICHTUNG VON ELEKTRODENHALTERUNGEN IN CVD REAKTOREN**
DEVICE FOR INSULATING AND SEALING ELECTRODE HOLDERS IN CVD REACTORS
DISPOSITIF D'ISOLEMENT ET D'ÉTANCHÉITÉ DE SUPPORTS D'ÉLECTRODE DANS DES RÉACTEURS CVD

(30) Priorität: 17.11.2014 DE 102014223415
(43) Veröffentlichungstag der Anmeldung: 27.09.2017
(73) Patentinhaber: Wacker Chemie AG, 81737 München (DE)
(72) Erfinder: KRAUS, Heinz, 84367 Zeilarn (DE); KUTZA, Christian, 84539 Ampfling (DE); RENNSCHMID, Dominik, 84489 Burghausen (DE)
(74) Vertreter: Potten, Holger
(86) Internationale Anmeldenummer: PCT/EP2015/075933
(87) Internationale Veröffentlichungsnummer: WO 2016/078938

(56) Entgegenhaltungen:
- EP-A2- 2 161 241
- WO-A1-2014/143910
- CN-A- 101 565 184
- CN-Y- 201 424 378

## Beschreibung

Die Erfindung betrifft eine Vorrichtung zur Isolierung und Abdichtung von Elektrodenhalterungen in einem Reaktor zur Abscheidung von polykristallinem Silicium sowie ein Verfahren zur Herstellung von polykristallinem Silicium mit Hilfe einer solchen Vorrichtung.

Hochreines Silicium wird in der Regel mittels des Siemens-Verfahrens hergestellt. Dabei wird ein Reaktionsgas enthaltend Wasserstoff und eine oder mehrere siliciumhaltige Komponenten in den Reaktor, bestückt mit dem durch den direkten Stromdurchgang erhitzen Trägerkörpern, eingeleitet, an denen sich Si in fester Form abscheidet. Als Silicium enthaltende Verbindungen werden bevorzugt Silan (SiH₄), Monochlorsilan (SiH₃Cl), Dichlorsilan (SiH₂Cl₂), Trichlorsilan (SiHCl₃), Tetrachlorsilan (SiCl₄) bzw. deren Mischungen eingesetzt.

Jeder Trägerkörper besteht meistens aus zwei dünnen Filamentstäben und einer Brücke, die in der Regel benachbarte Stäbe an ihren freien Enden verbindet. Am häufigsten werden die Filamentstäbe aus ein- oder polykristallinem Silicium gefertigt, seltener kommen Metalle bzw. Legierungen oder Kohlenstoff zum Einsatz. Die Filamentstäbe stecken senkrecht in am Reaktorboden befindlichen Elektroden über die der Anschluss an die Elektrodenhalterung und Stromversorgung erfolgt. An den erhitzten Filamentstäben und der waagrechten Brücke scheidet sich hochreines Polysilicium ab, wodurch deren Durchmesser mit der Zeit anwächst. Nachdem der gewünschte Durchmesser erreicht ist, wird der Prozess beendet.

Die Siliciumstäbe werden im CVD Reaktor von speziellen Elektroden gehalten, die in der Regel aus Graphit bestehen. Jeweils zwei Filamentstäbe mit unterschiedlicher Spannungspolung an den Elektrodenhalterungen sind am anderen Dünnstabende mit einer Brücke zu einem geschlossenen Stromkreis verbunden. Über die Elektroden und deren Elektrodenhalterungen wird elektrische Energie zur Beheizung der Dünnstäbe zugeführt. Dabei wächst der Durchmesser der Dünnstäbe. Gleichzeitig wächst die Elektrode, beginnend an ihrer Spitze, in den Stabfuß der Siliciumstäbe ein.

Nach dem Erreichen eines gewünschten Solldurchmessers der Siliciumstäbe wird der Abscheideprozess beendet, die Siliciumstäbe abgekühlt und ausgebaut.

Eine besondere Bedeutung kommt der Abdichtung der durch die Bodenplatte geführten Elektrodenhalterung zu. Zu diesem Zweck ist der Einsatz von Elektrodendichtungskörpern vorgeschlagen worden, wobei insbesondere der Anordnung und der Form der Elektrodendichtungskörper sowie dem verwendeten Material Bedeutung zukommt.

Zwischen dem in die Abscheideanlage hinein ragenden Kopf der Elektrodenhalterung und der Bodenplatte befindet sich ein ringförmiger Körper. Dieser hat üblicherweise zwei Funktionen: 1. Abdichtung der Durchführung der Elektrodenhalterung und 2. elektrische Isolation der Elektrodenhalterung zur Bodenplatte hin.

Aufgrund der hohen Gasraumtemperatur im CVD-Reaktor ist ein thermischer Schutz eines auf Kohlenwasserstoff basierenden Dichtkörpers notwendig. Ungenügende thermische Schutzwirkung bedeutet vorzeitigen Verschleiß der Dichtkörper durch Verschmoren der Dichtkörper, thermisch bedingtes Fließen des Dichtkörpers, Undichtigkeit des Reaktors, Unterschreiten des Mindestabstands zwischen Elektrodenhalterung und Bodenplatte und Erdschluss an verkohlten Dichtkörpern. Erdschluss oder Undichtigkeiten haben einen Ausfall der Abscheideanlage und damit einen Abbruch des Abscheideprozesses zur Folge. Dies verursacht eine verminderte Ausbeute und höhere Kosten.

Aus US 20110305604 A1 ist bekannt, die Dichtungen der Elektroden mittels Schutzringen aus Quarz gegen thermische Belastung abzuschirmen. Der Reaktorboden weist eine spezielle Ausgestaltung auf. Der Reaktorboden umfasst einen ersten Bereich und einen zweiten Bereich. Der erste Bereich ist durch eine dem Innenraum des Reaktors zugewandte Platte und einer Zwischenplatte, die die Düsen trägt, gebildet. Der zweite Bereich des Reaktorbodens ist durch die Zwischenplatte und eine Bodenplatte, die die Versorgungsanschlüsse für die Filamente trägt, gebildet. In den so gebildeten ersten Bereich wird das Kühlwasser geführt, um somit den Reaktorboden zu kühlen. Die Filamente selbst sitzen in einem Graphitadapter. Dieser Graphitadapter greift in einen Graphitspannring ein, der selbst über einen Quarzring mit der Platte zusammenwirkt. Die Kühlwasseranschlüsse für die Filamente können in Form von Schnellkupplungen ausgebildet sein.

WO 2011116990 A1 beschreibt eine Elektrodenhalterung mit einem Quarzabdeckring. Die Prozesskammereinheit besteht aus einer Kontakt- und Spanneinheit, einem Grundelement, einer Quarzabdeckscheibe und einem Quarzabdeckring. Die Kontakt- und Spanneinheit besteht aus mehreren, relativ zueinander bewegbaren Kontaktelementen, die einen Aufnahmeraum für einen Silicium-Dünnstab bilden. Die Kontakt- und Spanneinheit ist in einen entsprechenden Aufnahmeraum des Grundelements einführbar, wobei sich bei der Einführung in das Grundelement der Aufnahmeraum für den Silicium-Dünnstab verengt, und dieser dadurch sicher eingespannt und elektrisch kontaktiert wird. Das Grundelement besitzt auch eine untere Aufnahme zum Aufnehmen einer Kontaktspitze der Durchführeinheit. Die Quarzabdeckscheibe besitzt Mittelöffnungen zur Durchführung der Kontaktspitze der Durchführeinheit. Der Quarzabdeckring ist derart bemessen, dass er einen innerhalb einer Prozesskammer eines CVD-Reaktors liegenden Bereich der Durchführeinheit wenigstens teilweise radial umgeben kann.

Da Quarz eine niedrige Wärmeleitfähigkeit besitzt, werden allerdings diese Bauteile bei Abscheidebedingungen so heiß, dass auf ihrer Oberfläche eine dünne Siliciumschicht mit hoher Temperatur aufwächst. Bei diesen Bedingungen ist die Siliciumschicht elektrisch leitend, was zu einem Erdschluss führt.

WO 2011092276 A1 beschreibt eine Elektrodenhalterung, bei der das Dichtelement zwischen Elektrodenhalterung und Bodenplatte durch einen umlaufenden Keramikring vor Temperatureinflüssen geschützt wird. Mehrere Elektroden sind in einem Boden des Reaktors befestigt. Die Elektroden tragen dabei Filamentstäbe, die in einem Elektrodenkörper sitzen und über den die Stromzufuhr zu den Elektroden bzw. Filamentstäben erfolgt. Der Elektrodenkörper selbst ist mit mehreren elastischen Elementen in Richtung der Oberseite des Bodens des Reaktors hin mechanisch vorgespannt. Zwischen der Oberseite des Bodens des Reaktors und einem zur Oberseite des Bodens parallelen Ring des Elektrodenkörpers ist ein radial umlaufendes Dichtelement eingesetzt. Das Dichtelement selbst ist im Bereich zwischen der Oberseite des Bodens des Reaktors und dem dazu parallelen Ring des Elektrodenkörpers von einem Keramikring abgeschirmt.
Das Dichtelement besteht aus PTFE und übernimmt zugleich Dicht- und Isolierfunktion. Der Keramikring dient als Hitzeschild für den Dichtring.
Allerdings führt eine thermische Belastung von PTFE über 250 °C zum Verschmoren / Cracken an der Dichtungsoberfläche sowie zum Fließen des Dichtkörpers. Dadurch unterschreitet der Abstand zwischen Kopf der Elektrodenhalterung und Bodenplatte einen Mindestabstand und führt zu elektrischen Überschlägen/Erdschlüssen von Elektrodenhalterung zur Bodenplatte. Das Verschmoren / Cracken setzt zudem Kohlenstoffverbindungen frei, die zu einer Verunreinigung der abzuscheidenden Siliciumstäbe durch Einbau von Kohlenstoff führen.

US 20130011581 A1 offenbart eine Vorrichtung zum Schutz von Elektrodenhalterungen in CVD Reaktoren, umfassend eine zur Aufnahme eines Filamentstabs geeigneten Elektrode auf einer Elektrodenhalterung aus einem elektrisch leitfähigen Material, die in einer Aussparung einer Bodenplatte angebracht ist, wobei ein Zwischenraum zwischen Elektrodenhalterung und Bodenplatte mit einem Dichtungsmaterial abgedichtet ist und das Dichtungsmaterial durch einen ein- oder mehrteilig aufgebauten, ringförmig um die Elektroden angeordneten Schutzkörper geschützt wird, wobei der Schutzkörper in Richtung der Elektrodenhalterung zumindest abschnittsweise in seiner Höhe zunimmt. Dabei sind geometrische Körper in konzentrischer Anordnung um die Elektrodenhalterung vorgesehen, deren Höhe mit zunehmendem Abstand von der Elektrodenhalterung abnimmt. Es kann sich auch um einen einteiligen Körper handeln. Dies dient dem thermischen Schutz des Dichtungs- und Isolierungskörpers der Elektrodenhalterung sowie einer Strömungsmodifikation am Stabfuß der abgeschiedenen Polysilicium-Stäbe, die die Umfallquote positiv beeinflusst.

Bei den Vorrichtungen nach WO 2011092276 A1 und nach US 20130011581 A1 kann es zwischen Elektrodenhalterung und Bodenplatte zu einem Erdschluss infolge von Siliciumsplittern kommen, die aufgrund von thermischen Verspannungen wegen des hohen Feeddurchsatzes von den Siliciumstäben abplatzen, zwischen Elektrodenhalterung und Keramikring / Schutzkörper fallen und dort eine elektrisch leitende Verbindung zwischen Elektrodenhalterung und Bodenplatte herstellen. Kurzschlüsse bedeuten ein abruptes Prozessende durch Ausfall der Stromversorgung zur Beheizung der Stäbe. Die Stäbe können nicht bis zum vorgesehenen Enddurchmesser abgeschieden werden. Mit dünneren Stäben fällt die Anlagenkapazität niedriger aus, was erhebliche Kosten verursacht.

CN 202193621 U offenbart eine Vorrichtung, bei der zwei Keramikringe zwischen Kopf der Elektrodenhalterung und Bodenplatte mit dazwischen liegender Graphitflachdichtung vorgesehen sind.
Hier besteht allerdings keine Dichtfunktion zwischen Keramikring und Kopf der Elektrodenhalterung sowie zwischen Keramikring und Bodenplatte. Undichtigkeiten des Reaktors sind die Folge.

CN 101565184 A offenbart einen Isolierring aus Zirkonoxidkeramik (ZrO2) zwischen Kopf der Elektrodenhalterung und der Bodenplatte. Der Isolierring ist in der Bodenplatte versenkt. Deshalb ist ein zusätzlicher Quarzring zur Isolierung zwischen Kopf der Elektrodenhalterung und Bodenplatte notwendig. Die Abdichtung erfolgt mittels zweier Graphitflachdichtungen zwischen Kopf der Elektrodenhalterung und Isolierring sowie zwischen Bodenplatte und Isolierring. Als zusätzliche Abdichtung wird ein O-Ring an der Elektrodendurchführung unterhalb der Bodenplatte eingesetzt.

CN 102616783 A offenbart einen Isolierring aus Keramik zwischen Kopf der Elektrodenhalterung und der Bodenplatte. Die Abdichtung erfolgt mittels zweier metalleingefasster Graphitflachdichtungen ober- und unterhalb des Isolierrings zum Kopf der Elektrodenhalterung bzw. zur Bodenplatte hin.
Bei den beiden zuletzt genannten Schriften besteht die Problematik, dass eine hohe Flächenpressung für die Graphitflachdichtung zur Abdichtung notwendig ist. Da Keramik spröde ist und eine geringe Biegefestigkeit aufweist, werden hohe Anforderungen an die Ebenheit der Dichtflächen von Bodenplatte und Kopf der Elektrodenhalterung gestellt. Bei kleinsten Unebenheiten, die in der Praxis kaum zu vermeiden sind, kommt es aufgrund der hohen Flächenpressung zum Bruch der Keramikringe. Undichtigkeiten des Reaktors sind die Folge.

WO 2014/143910 A1 offenbart einen Dichtungsring zwischen Bodenplatte und Elektrodenhalterung umfassend einen Grundkörper aus einem keramischen Material mit einer oberen und einer unteren Rille, wobei in die Rillen jeweils Dichtungselemente eingesetzt werden.
Allerdings hat sich gezeigt, dass die in Rillen des Keramikrings eingesetzten Dichtungselemente hohen thermischen Belastungen ausgesetzt sind. Dynamische Temperaturänderungen an den Dichtelementen können zu Bewegungen an den Dichtelementen führen, verursacht durch thermische Ausdehnung / Zusammenziehen von Elektrodenhalterung, Bodenplatte und Dichtung. Dadurch können die Oberflächen der Dichtelemente geschädigt werden, was zu Leckagen an den Dichtungen führen kann. Dies macht häufige Dichtungswechsel erforderlich, was eine verminderte Standzeit des Reaktors bedeutet.
US 2010058988 A1 sieht eine Fixierung der Elektrodenhalterung in der Bodenplatte durch ein konisches PTFE-Dicht- und Isolierelement vor. Das konische PTFE-Dichtelement wird an seiner Oberseite über einen Bund (Querschnittserweiterung) an der Elektrodenhalterung verpresst. Zusätzlich ist zwischen Dichtelement und Elektrodendurchführung durch die Bodenplatte sowie zwischen Dichtelement und Schaft der Elektrodenhalterung jeweils ein O-Ring vorgesehen.
Durch die Verpressung des konischen Dichtelements ist der Ausbau der Elektrodenhalterung erschwert. Durch Fließen des PTFE-Dichtkörpers kann der Mindestabstand zwischen Elektrodenhalterung und Bodenplatte unterschritten werden. Elektrische Überschläge / Erdschlüsse sind die Folge.
Aus dieser Problematik ergab sich die Aufgabenstellung der Erfindung.
Die Aufgabe wird gelöst durch eine Vorrichtung zur Isolierung und Abdichtung von Elektrodenhalterungen in CVD Reaktoren gemäß Anspruch1, umfassend eine zur Aufnahme eines Filamentstabs geeignete Elektrode auf einer Elektrodenhalterung aus einem elektrisch leitfähigen Material, die in einer Aussparung einer Bodenplatte angebracht ist, wobei zwischen Elektrodenhalterung und Bodenplatte ein elektrisch isolierender Ring aus einem Werkstoff mit einer spezifischen Wärmeleitfähigkeit bei Raumtemperatur von 1 - 200 W/mK, einer Dauertemperaturbeständigkeit von größer oder gleich 400°C und einem spezifischen elektrischen Widerstand bei Raumtemperatur von größer als 10⁹ Ωcm vorgesehen ist, wobei mindestens zwei ringförmige Dichtelemente zur Abdichtung zwischen Elektrodenhalterung und Bodenplatte vorhanden sind, wobei der elektrisch isolierende Ring oder die Elektrodenhalterung oder die Bodenplatte Nuten umfassen, in denen die Dichtelemente fixiert sind, wobei wenigstens eines der Dichtelemente in einer in der Elektrodenhalterung oder in einer in der Bodenplatte angebrachten, oberhalb oder unterhalb des elektrisch isolierende Rings befindlichen Nut fixiert ist.
Die Aufgabe der Erfindung wird auch gelöst durch ein Verfahren zur Herstellung von polykristallinem Silizium gemäß Anspruch 16, umfassend Einleiten eines Reaktionsgases enthaltend eine Silicium enthaltende Komponente und Wasserstoff in einen CVD Reaktor enthaltend wenigstens einen Filamentstab, der sich auf einer erfindungsgemäßen Vorrichtung oder auf einer Vorrichtung gemäß einer der bevorzugten Ausführungsformen befindet, der mittels der Elektrode mit Strom versorgt und der damit durch direkten Stromdurchgang auf eine Temperatur aufgeheizt wird, bei der sich polykristallines Silicium am Filamentstab abscheidet.
Bevorzugte Ausführungsformen der Erfindung sind den anhängigen Ansprüchen und der nachfolgenden Beschreibung zu entnehmen.
Die Erfindung sieht vor, Dicht- und Isolierkörper zu trennen bzw. Dicht- und Isolierfunktionen auf zwei Bauteile aufzuteilen, wobei ein Isolierring für die elektrische Isolation und ein Dichtungsteil für die Abdichtung vorgesehen sind.
Dies ermöglicht es, für Isolierring und Dichtungsteil unterschiedliche Werkstoffe zu wählen, die für die jeweiligen Funktionen der beiden Bauteile besser geeignet sind.
Dabei sollte der Isolierring hochtemperaturbeständig und formstabil sein, während eine abdichtende Funktion nicht notwendig ist. Durch die höhere Formstabilität können höhere Isolierringe verwendet werden. Der größere Abstand zwischen Elektrodenhalterung und Bodenplatte erlaubt das Anlegen von höherer elektrischer Spannung. Dies hat den Vorteil, dass mehrere Stabpaare in Reihe verschaltet werden können und somit Investitionskosten bei der Stromversorgung des Reaktors eingespart werden können.

Die Platzierung der Dichtelemente in einer Nut der Elektrodenhalterung und / oder in einer Nut der Bodenplatte hat den Vorteil, dass die die Dichtelemente vom Kopf der Elektrodenhalterung und / oder der Bodenplatte gekühlt werden können. Elektrodenhalterung und Bodenplatte sind mit einem Kühlmittel durchflossen.

Dadurch werden die Dichtelemente weniger stark thermisch belastet. Eine niedrigere thermische Belastung der Dichtelemente hat eine längere Standzeit bzw. Haltbarkeit der Dichtung zur Folge.

Der Kopf der Elektrodenhalterung kann in einer Ausführungsform gegenüber dem Isolierring einen Überstand **c** haben. Dies sorgt für einen weiteren thermischen und mechanischen Schutz. Der Isolierring wird vor Wärmestrahlung abgeschattet und weniger stark belastet. Auch die Temperaturbelastung der Dichtelemente nimmt ab.

Ein Überstand ist dann gegeben, wenn der Außendurchmesser **D_E** der Elektrodenhalterung größer ist als der Außendurchmesser **D_R** des Isolierrings.

Der Überstand **c** kann bis zum achtfachen der Höhe des Isolierrings betragen. Besonders bevorzugt ist ein Überstand von bis zum vierfachen der Höhe des Isolierrings.

Die Nuten zur Aufnahme der Dichtelemente können sowohl in den Isolierringen als auch in der Bodenplatte und/oder im Kopf der Elektrodenhalterung sein, wobei jedoch zumindest eine Nut in Elektrodenhalterung oder Bodenplatte vorhanden ist.

Die Erfinder haben erkannt, dass eine aus dem Stand der Technik bekannte Ausführung, wonach sich beide Nuten zur Aufnahme der Dichtelemente im Isolierring befinden, nachteilig ist. Die Standzeit der Dichtelemente ist deutlich höher, wenn sich zumindest eine Nut nicht im Isolierring, sondern entweder in der Elektrodenhalterung oder in der Bodenplatte befindet. Dies hängt damit zusammen, dass Elektrodenhalterung und Bodenplatte kühlbar sind, was die thermische Belastung der Dichtelemente auch in großen Reaktoren und bei hohen Abscheidetemperaturen signifikant reduziert.

Die Nuten befinden sich vorzugweise in einem Abstand a von 10-40% der Gesamtbreite b des Isolierrings zur Elektrodendurchführung (Innendurchmesser Isolierring). Dadurch sind die Dichtelemente ausreichend weit von der dem Reaktor zugewandten Seite des Isolierrings entfernt. Dies ist in Hinblick auf die thermische Belastung der Dichtelemente von Vorteil.

In einer weiteren Ausführungsform können die Nuten auch an gleicher Position (Abstand a von 10-40% der Gesamtbreite b des Isolierrings zur Elektrodendurchführung) in der Bodenplatte und im Kopf der Elektrodenhalterung sein. Der Isolierring hat in diesem Fall keine Nuten.

Die in Nuten von Elektrodenhalterung oder Bodenplatte fixierten Dichtelemente werden vorzugweise vom Kühlmedium in der Bodenplatte und in der Elektrodenhalterung gekühlt. Aufgrund der Kühlung nehmen die Dichtelemente eine deutlich geringere Temperatur als der Isolierring an.

Die dem Reaktorinnenraum zugewandte Seite des Isolierrings hat eine Oberflächentemperatur von bis zu 600°C.

Da alle Teile, insbesondere der Isolierring, mit der Reaktionsatmosphäre in Berührung kommen, müssen sie zusätzlich in einer HCl / Chlorsilanatmosphäre chemisch beständig sein.

Eine geringe Wärmeleitfähigkeit des Isolierrings begünstigt die niedrige Temperaturbelastung der Dichtelemente. Andererseits wird durch niedrige Wärmeleitfähigkeit des Isolierrings dessen Oberflächentemperatur zur Reaktorseite hin höher. Die Oberflächentemperatur darf nicht so hoch werden, dass sich elektrisch leitfähiger siliciumhaltiger Belag auf den Isolierringen abscheidet. Die Materialwahl mit passender spezifischer Wärmeleitfähigkeit des Isolierkörpers ist für seine störungsfreie Funktion von großer Bedeutung.

Die innenliegenden Dichtelemente sind gegenüber einer Flachdichtung oder anderen Dichtungsformen besser gegen thermische Einflüsse aus dem Reaktionsraum (heißes Reaktionsgas, Wärmestrahlung) geschützt.

Im Vergleich zu einem einteiligen Dicht- und Isolierring, können die Materialeigenschaften bei mehrteiligen Konstruktionen besser auf die jeweiligen Anforderungen an die Dicht- und Isolierfunktion ausgelegt werden.

Der Isolierring benötigt keine abdichtenden Materialeigenschaften.

Die spezifische Wärmeleitfähigkeit bei Raumtemperatur des Isolierrings liegt im Bereich von 1 - 200 W/mK, bevorzugt 1 - 50 W/mK, besonders bevorzugt 1 - 5 W/mK.

Der spezifische elektrische Widerstand des Isolierrings bei Raumtemperatur ist größer als 10⁹ Ωcm, vorzugsweise größer 10¹¹ Ωcm besonders bevorzugt 10¹³ Ωcm.

Zum Ausgleich von Unebenheiten auf den Auflageflächen von Bodenplatte und Kopf der Elektrodenhalterung, sollte der Isolierring eine Mindestbiegefestigkeit aufweisen. Die Biegefestigkeit des Isolierrings sollte größer sein als (bestimmt nach DIN EN 843 für Keramik) 120 MPa, bevorzugt größer 200 MPa, besonders bevorzugt größer 500 MPa.

Als Materialien für den Isolierring kommen daher in Frage: Aluminiumoxid (Al₂O₃); Siliciumnitrid (Si₃N₄); Bornitrid (BN); Zirkonoxid (ZrO₂), Zirkonoxid stabilisiert mit Yttriumoxid (ZrO₂-Y₂O₃), mit Magnesiumoxid (ZrO₂-MgO) oder mit Calciumoxid (ZrO₂-CaO).

Besonders bevorzugt ist die Verwendung von mit Yttriumoxid stabilisiertem Zirkonoxid. Dieses Material zeigte die beste Temperaturbeständigkeit und Formstabilität. Weiterhin hat es aufgrund des Zusatzes von Yttriumoxid eine sehr hohe Biegefestigkeit (bei 20°C > 1000MPa).

Die Dichtelemente sollten einer Temperaturdauerbelastung von 300 -500 °C standhalten. Zudem sollten gegenüber HCl/Chlorsilan-Atmosphäre bei 300 - 500 °C beständig sein.

Die Dichtelemente können sowohl eine gekrümmte Oberfläche oder eine ebene Oberfläche aufweisen. Bei ebener Oberfläche stehen die Dichtelemente im unverpressten Zustand über die Nut hinaus.

Im verpressten Zustand wird der Kopf der Elektrodenhalterung über den Isolierring mit der Bodenplatte auf Block gezogen. Die Dichtelemente werden in der Nut eingeschlossen und stehen nicht mehr über die Nut hinaus. Die Dichtelemente liegen somit im Kraftnebenschluss.

Vorzugweise handelte sich bei den Dichtelementen um O-Ringe aus einem elastomeren Werkstoff. Geeignet sind beispielsweise O-Ringe aus Fluorelastomere (FPM, nach ISO 1629), Perfluorelastomere (FFKM, ASTM D-1418) und Silikon-Elastomere (MVQ, ISO 1629).

In einer weiteren Ausführungsform handelt es sich um Dichtungen aus Graphit.

Bei den Dichtelementen aus Graphit handelt es sich vorzugweise um Graphitschnüre aus geflochtenen Graphitfasern oder um Graphitfolienringe.

Besonders bevorzugt ist die Verwendung von Graphitfolienringen. Ein Graphitfolienring besteht aus mehreren zusammengepressten Graphitlagen. Die Dauertemperaturbeständigkeit dieser Dichtelemente aus Graphit liegt bei bis zu 600°C.

Bei den Dichtelementen aus Graphit genügen geringe Verpresskräfte, da die Dichtfläche sehr klein ist. Die Dichtfläche wird durch die Abmessungen der Nut bestimmt. Die Dichtfläche liegt vorzugweise zwischen 600 und 3000 mm², besonders bevorzugt zwischen 600 und 2000 mm², und ganz besonders bevorzugt zwischen 600 und 1500 mm². Dies hat nur eine geringe mechanische Belastung auf den Isolierring zur Folge, was Brüche der Isolierringe verhindert.

In einer weiteren Ausführungsform handelt es sich um Dichtungen aus Metall.
Bei den Dichtelementen aus Metall handelt es sich vorzugweise um metallische Ringfederdichtungen. Aufgrund der geringen Dichtflächen der metallischen Dichtelemente genügt auch hier zur Abdichtung eine geringe Verpresskraft. Unter geringer Verpresskraft wird bei den Metalldichtelementen eine Verpresskraft von 60 - 300 N/mm Dichtungsumfang, bevorzugt 60 - 200 N/mm Dichtungsumfang, besonders bevorzugt 60 - 160 N/mm Dichtungsumfang verstanden.

Die metallischen Dichtungen weisen vorzugweise eine der folgenden Formen auf:
- geschlossener, innen hohler O-Ring (hohler Metall-O-Ring);
- offene Metallprofile, z.B. C-förmig, U-förmig, E-förmig oder beliebige andere Profile mit Federwirkung, z.B. wellige Metalldichtringe;
- offene Metallprofile können federgestützt sein, z.B. ein C-Ring mit zusätzlicher innenliegender Spiralfeder.

Ein C-Ring ist ein hohler O-Ring mit offener Innen- oder Außenseite.

Die metallischen Dichtelemente können zur Erhöhung der chemischen Beständigkeit und zur Erhöhung der Dichtwirkung mit duktilen Metallen beschichtet werden, z.B. mit Silber, Gold, Kupfer, Nickel oder mit einem anderen duktilen und in einer HCl / Chlorsilanatmosphäre beständigem Metall.

Durch die Fließfähigkeit dieser duktilen Beschichtungsmaterialien wird die Dichtwirkung der metallischen Dichtelemente deutlich erhöht. Die Dauertemperaturbeständigkeit dieser Dichtelemente aus Metall liegt bei bis zu 850°C.

Unter duktilen Beschichtungsmaterialien werden Metalle verstanden, bei denen sich die Korngrenzen und Versetzungen bei mechanischer Belastung schon bei einer Dehnung unterhalb der Bruchdehnung bewegen, bzw. fließen. Durch dieses Fließen bei einer Belastung unter Krafteinwirkung, wie es bei einer Verpressung gegeben ist, werden Unebenheiten der Dichtflächen ausgeglichen. Dadurch wird eine bessere Abdichtung erreicht.

Besonders bevorzugt ist die Verwendung eines mit Silber beschichteten Metall-C-Rings mit oder ohne innen liegender Spiralfeder.

Andererseits können große Temperaturwechsel an den metallischen Dichtelementen, z.B. beim An- und Abfahren der Chargen, aufgrund thermischer Ausdehnung der Dichtelemente zu mechanischen Schäden an der Dichtfläche der Dichtelemente führen.

In einer weiteren Ausführungsform handelt es sich um eine Dichtung, bestehend aus 2 Werkstoffen, einem flexiblen Werkstoff, beispielsweise ein zu einem Kreis gefügtem Metallband mit mindestens einem Knick oder Bogen, das bei Verpressung eine Rückstellkraft gewährleistet und einem Füllstoff.

Der Dichtkörper besteht aus mehreren zu Kreisen zusammen gefügten Metallbändern mit unterschiedlichen Durchmessern, die ineinander gestellt sind.

Zwischen den einzelnen Kreisen befindet sich ein Füllstoff, beispielweise Graphit oder PTFE, der die Dichtwirkung erzeugt.

Bevorzugt handelt es sich um eine Spiraldichtung. Hierbei handelt es sich um ein mehrlagig aufgewickeltes Metallband mit mindestens einem Knick oder Bogen. Zwischen den einzelnen Lagen befindet sich der Füllstoff. Bei Verpressung dichtet der Füllstoff ab. Das geknickte Metallband erzeugt eine Rückstellkraft und gewährleistet die Flexibilität der Dichtung.

Bevorzugte Metalle sind Edelstähle, Hastelloy, Inconel und Nickel.

Hastelloy ist der Markenname einer Nickelbasislegierung der Firma Haynes International, Inc.

Inconel ist ein Markenname der Firma Special Metals Corporation für eine Reihe von korrosionsbeständigen Nickelbasislegierungen.

Der bevorzugte Füllstoff ist Graphit.

Die bezüglich der vorstehend aufgeführten Ausführungsformen des erfindungsgemäßen Verfahrens angegebenen Merkmale können entsprechend auf die erfindungsgemäße Vorrichtung übertragen werden. Umgekehrt können die bezüglich der vorstehend ausgeführten Ausführungsformen der erfindungsgemäßen Vorrichtung angegebenen Merkmale entsprechend auf das erfindungsgemäße Verfahren übertragen werden. Diese und andere Merkmale der erfindungsgemäßen Ausführungsformen werden in der Figurenbeschreibung und in den Ansprüchen erläutert. Die einzelnen Merkmale können entweder separat oder in Kombination als Ausführungsformen der Erfindung verwirklicht werden. Weiterhin können sie vorteilhafte Ausführungen beschreiben, die selbstständig schutzfähig sind.

Die Erfindung wird im Folgenden auch anhand der **Fig. 1** bis **9** erläutert.

### Kurzbeschreibung der Figuren

**Fig. 1** zeigt eine schematische Darstellung eines montierten Isolierrings und einer oberen Nut mit Dichtelement in der Elektrodenhalterung und einer unteren Nut mit Dichtelement in der Bodenplatte..
**Fig. 2** zeigt eine schematische Darstellung eines montierten Isolierrings mit einer oberen Nut mit Dichtelement in der Elektrodenhalterung und einer Nut mit Dichtelement im Isolierring sowie mit Überstand des Kopfes der Elektrodenhalterung.
**Fig. 3** zeigt eine schematische Darstellung eines Isolierrings mit einer Nut an der Unterseite.
**Fig. 4** zeigt eine schematische Darstellung eines montierten Isolierrings mit einer unteren Nut in der Bodenplatte und einer oberen Nut im Kopf der Elektrodenhalterung sowie mit Überstand des Kopfes der Elektrodenhalterung.
**Fig. 5** zeigt eine schematische Darstellung eines Isolierrings ohne Nut.
**Fig. 6** zeigt einen Querschnitt durch einen Metall-C-Ring.
**Fig. 7** zeigt Querschnitte durch weitere Ausführungen für Dichtelemente aus Metall.
**Fig. 8** zeigt einen Querschnitt durch einen Graphitfolienring bestehend aus mehreren verpressten Einzelfolien.
**Fig. 9** zeigt einen Querschnitt durch eine Spiraldichtung.

### Liste der verwendeten Bezugszeichen

- **1**: Elektrodenhalterung
- **2**: Isolierring
- **3**: Bodenplatte
- **4**: Dichtelement
- **5**: Kühlung Bodenplatte
- **6**: Zulauf Kühlung Elektrodenhalterung
- **7**: Kühlung Elektrodenhalterung
- **8**: Isolierhülse
- **9**: Nut für Dichtelement
- **10**: Metallband
- **11**: Füllstoff
- **a**: Abstand Nut von Innendurchmesser
- **b**: Gesamtbreite
- **h**: Höhe Isolierring
- **c**: Überstand
- **D_E**: Außendurchmesser Elektrodenhalterung
- **D_R**: Außendurchmesser Isolierring

Zwischen Elektrodenhalterung **1** und Bodenplatte **3** befinden sich Isolierring **2** und Dichtelemente **4.**

Die Bodenplatte **3** ist mit einer Durchbohrung versehen, die mit einer Isolierhülse **8** ausgekleidet ist und durch die eine Elektrodenhalterung **1** hindurchgeführt und eingepasst ist.

Bodenplatte **3** und Elektrodenhalterung **1** werden durch Kühlungen **5** bzw. **7** gekühlt. **6** zeigt den Zulauf für die Kühlung **7** der Elektrodenhalterung **1.**

Die Abdichtung erfolgt durch Dichtelemente **4.**

Ein erstes Dichtelement **4** befindet sich einer Nut der Elektrodenhalterung **1.**

Ein zweites Dichtelement **4** befindet sich in einer Nut der Bodenplatte **3.**

Der Außendurchmesser **D_E** der Elektrodenhalterung **1** kann bezogen auf den Außendurchmesser **D_R** des Isolierrings **2** bündig oder überstehend sein. Bevorzugt ist die Elektrodenhalterung überstehend.

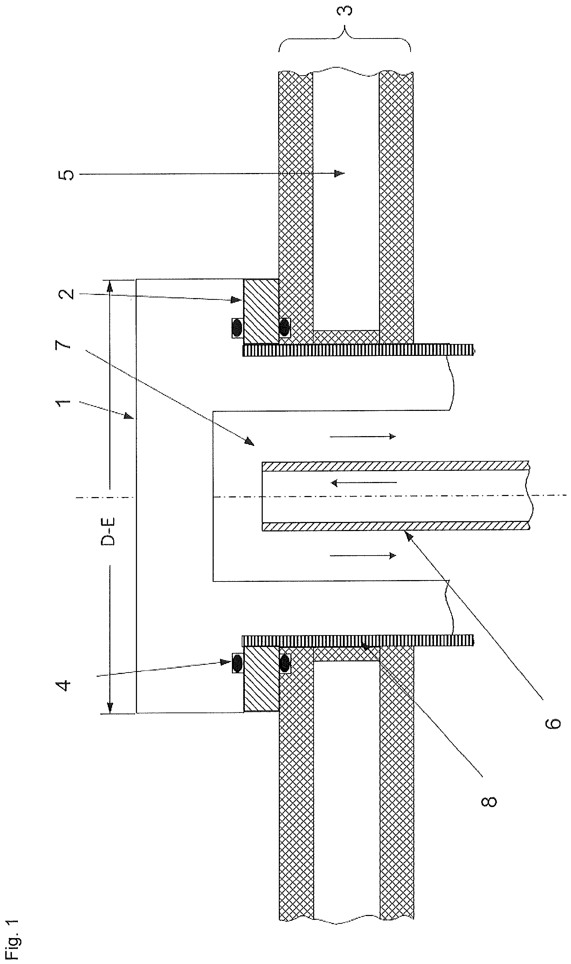

**Fig. 1** zeigt eine Ausführungsform ohne Überstand.

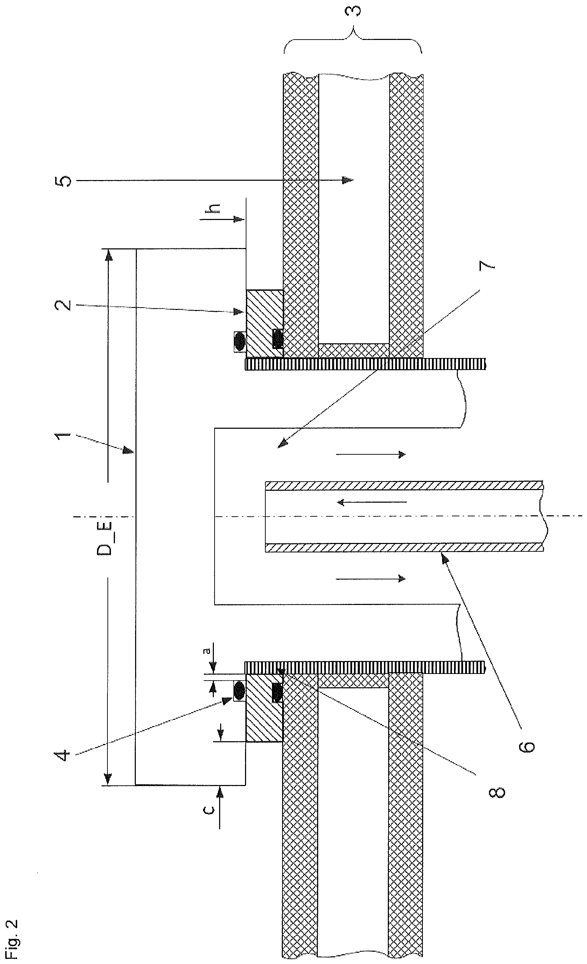

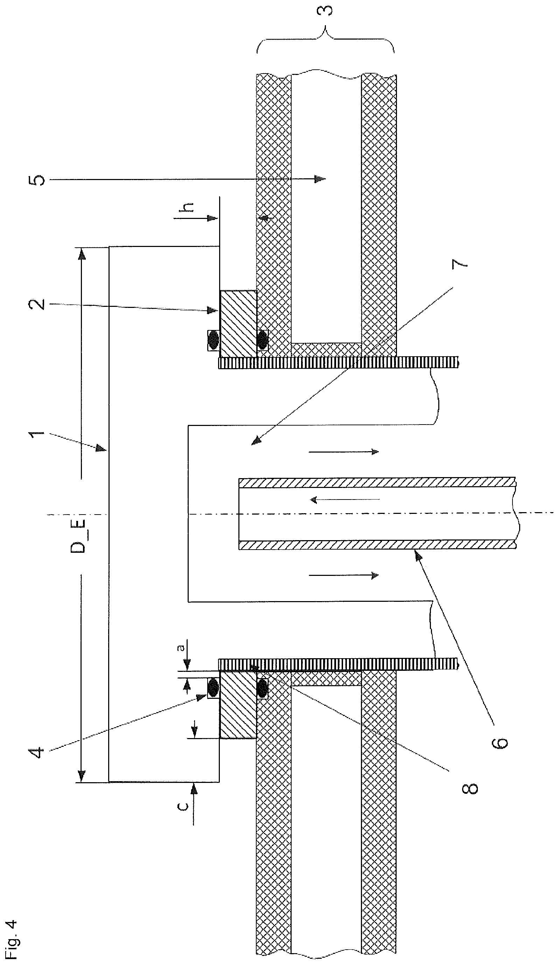

**Fig. 2** und **4** zeigen jeweils eine Ausführungsform mit Überstand **c.**

Als weiteren thermischen und mechanischen Schutz kann der Kopf der Elektrodenhalterung **1** also über die Außenkontur des Isolierrings **2** hinausragen. Der Überstand **c** sollte 0 - 8***h** betragen, wobei **h** der Höhe des Isolierrings **2** entspricht. Besonders bevorzugt ist ein Überstand von 0 - 4***h**.

**Fig. 2** zeigte eine Ausführungsform, bei der die Elektrodenhalterung **1** und der Isolierring **2** jeweils eine Nut zur Aufnahme eines Dichtelements **4** umfassen.

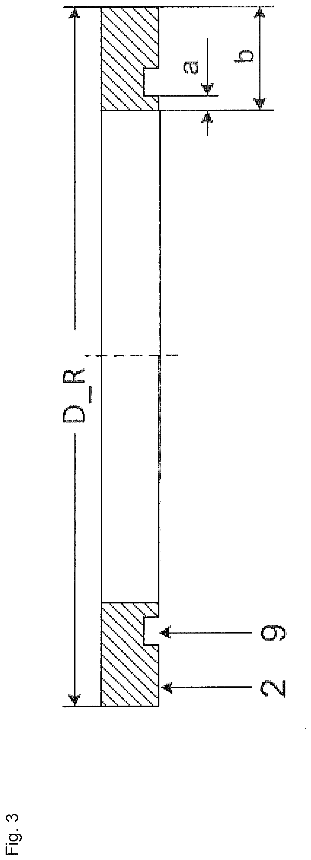

Die Nuten **9** des Isolierrings **2** befinden sich in einem Abstand **a** von 10-40% der Gesamtbreite **b** des Isolierrings zur Elektrodendurchführung, vgl. **Fig. 3****.** Im gleichen radialen Abstand von der Elektrodendurchführung befinden sich auch die Nuten in Bodenplatte **3** oder Elektrodenhalterung **1.**

Dadurch sind die Dichtelemente **4** ausreichend weit von der dem Reaktor zugewandten Seite des Isolierrings **2** entfernt. Dies ist vorteilhaft, da damit die thermische Belastung der Dichtelemente **4** gering ist. Die Dichtelemente 4 werden so besonders gut gekühlt, vom Kühlmedium in der Bodenplatte **2,** dem Kopf der Elektrodenhalterung **1** und der Durchführung der Elektrode durch die Bodenplatte **3.** Aufgrund der guten Kühlung können die Dichtelemente **4** Wärmeenergie an das Kühlmedium abgeben und werden somit nicht thermisch geschädigt.

**Fig. 4** zeigt eine schematische Darstellung eines montierten Isolierrings **2** mit den Nuten in der Bodenplatte **3** und im Kopf der Elektrodenhalterung **1** und Überstand des Kopfes der Elektrodenhalterung **1.** Es handelt sich um eine Ausführungsform mit Überstand **c.**

Hier befinden sich die Nuten zur Fixierung der Dichtelemente **4** nicht im Isolierring **2,** sondern in Elektrodenhalterung **1** und Bodenplatte **3.**

Dabei befinden sich die Nuten ebenso wie bei **Fig. 2** vorzugweise in einem Abstand **a** von 10-40% der Gesamtbreite **b** des Isolierrings **2** zur Elektrodendurchführung.

Die Dichtelemente **4** befinden sich also im gleichen Abstand von der Aussparung der Bodenplatte wie die Dichtelemente von **Fig. 2****,** wobei sie jedoch nicht in Nuten des Isolierrings **2,** sondern in Nuten von Elektrodenhalterung **1** und Bodenplatte **3** eingebracht sind.

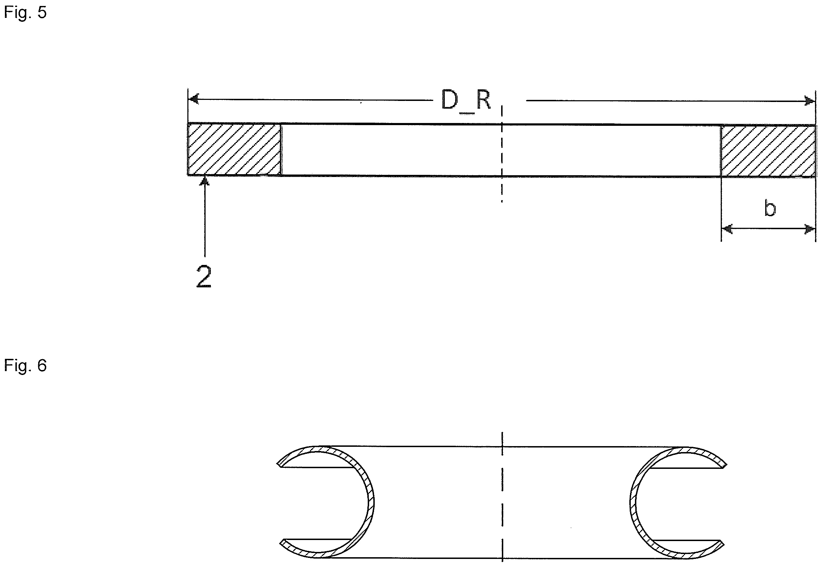

**Fig. 5** zeigt eine schematische Darstellung eines Isolierrings ohne Nut.
Ein solcher Isolierring kommt bei der Ausführung nach **Fig. 4** zum Einsatz.

**Fig. 6** zeigt einen Querschnitt durch ein metallisches Dichtelement mit C-Profil.

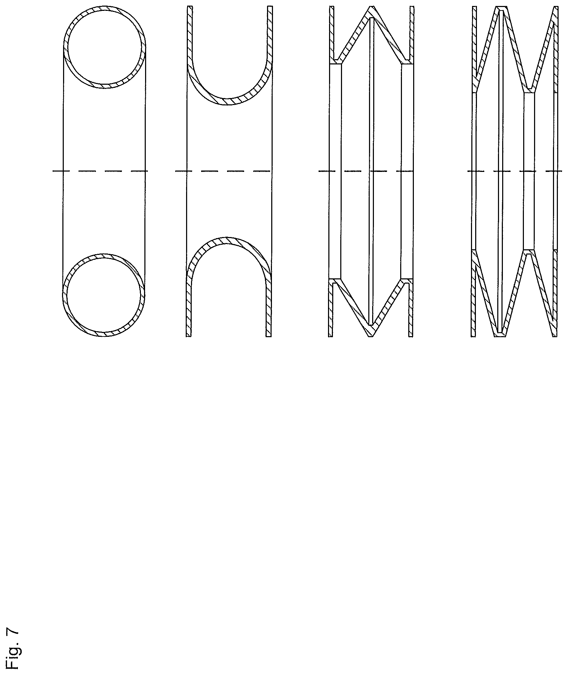

**Fig. 7** zeigt Querschnitte durch weitere Ausführungen für Dichtelemente aus Metall, O-Profil, U-Profil, E-Profil, Profil mit Federwirkung.

Beim E-Ring handelt es sich um einen doppelt gefalteten Doppel-U-Ring.

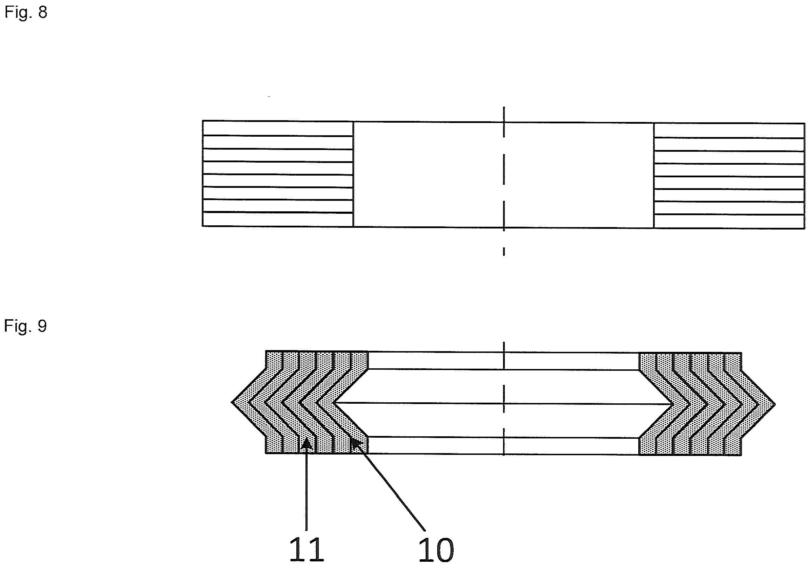

**Fig. 8** zeigt einen Querschnitt durch einen Graphitfolienring bestehend aus mehreren verpressten Einzelfolien.

**Fig. 9** zeigt einen Querschnitt durch eine Spiraldichtung, bestehend aus einem aufgewickeltem Metallband **10** mit mehreren Wicklungen und einem Füllstoff **11** zwischen den einzelnen Lagen der Wicklung.

### Beispiele

In einem Siemens Abscheidereaktor wurden polykristalline Siliciumstäbe mit einem Durchmesser zwischen 160 und 230 mm abgeschieden.

Dabei wurden mehrere Ausführungen an Isolierringen und Dichtelementen getestet. Die Ergebnisse dieser Tests werden nachfolgend an ausgewählten Beispielen und Vergleichsbeispielen erläutert.

Die Parameter des Abscheideprozesses waren bei allen Versuchen jeweils gleich. Die Abscheidetemperatur lag im Chargenverlauf zwischen 1000°C und 1100°C. Während des Abscheideprozesses wurde ein Feed bestehend aus einer oder mehreren chlorhaltigen Silanverbindungen der Formel SiHₙCl₄₋ₙ (mit n = 0 bis 4) und Wasserstoff als Trägergas zugegeben.

Die Versuche unterschieden sich ausschließlich in der Ausführung der Isolierringe und der Dichtelemente.

Zum Vergleich wurde zunächst ein PTFE-Isolierring untersucht, der gleichzeitig Dichtungs- und Isolierungsfunktionen übernimmt. In diesem ist also keine Funktionstrennung durch Isolierring und zusätzliche Dichtelemente vorgesehen.

Weiterhin wurden Isolierringe aus Zirkonoxid in Verbindung mit metallischen Dichtelementen getestet. Dichtelemente aus Graphit oder aus elastomeren Werkstoffen wie Perfluorelastomeren führen zu vergleichbaren Ergebnissen.

Vergleichsweise wurde eine Ausführung untersucht, bei der die Dichtelemente in Nuten des Zirkonoxid-Rings fixiert sind.

Es hat sich gezeigt, dass bei den vorteilhaften Ausführungen zumindest ein Dichtelement entweder in einer Nut der Bodenplatte oder in einer Nut der Elektrodenhalterung fixiert ist. Ein Überstand der Elektrodenhalterung gegenüber dem Isolierring kann die thermische Belastung der Dichtelemente weiter reduzieren.

### Vergleichsbeispiel 1

### CVD-Reaktor mit Isolierring aus PTFE:

Bei dieser Ausführungsform nach dem Stand der Technik übernimmt der Isolierring aus PTFE Dicht- und Isolierfunktion. Aufgrund der geringen Formstabilität ist die Höhe des Isolierrings auf 8 mm im Neuzustand begrenzt.

Wegen der hohen thermischen Belastung während des Betriebs und der notwendigen Presskraft von 35-40 kN zur Gewährleistung der Dichtfunktion des Isolierrings, reduzierte sich die Höhe des Isolierrings auf ein Mindestmaß von 4 mm innerhalb von 3 Monaten.

Dadurch ist die Standzeit auf 3 Monate begrenzt.

Aufgrund der thermischen Belastung durch das heiße Reaktionsgas war sowohl die Abdichtung der Bodenplatte als auch die elektrische Isolation durch thermisches Cracken und Setzen des Dichtkörpers nicht mehr gegeben. Nach dieser Zeit war deshalb ein aufwendiger Tausch aller Isolierringe notwendig. Reparaturarbeiten hatten einen erheblichen Kapazitätsverlust zur Folge.

### Vergleichsbeispiel 2

### CVD-Reaktor mit Isolierring aus Zirkonoxid (ZrO2):

Bei dieser Ausführung wird die Dicht- und Isolierfunktion auf zwei Bauteile aufgeteilt. Der Isolierring aus ZrO₂ wird zur elektrischen Isolierung zwischen Elektrodenhalterung und Bodenplatte eingesetzt. Der Isolierring ist 8 mm hoch im Neuzustand. Die Dichtfunktion übernimmt jeweils ein silberbeschichteter Metall-C-Ring zum Kopf der Elektrodenhalterung hin und zur Bodenplatte, wobei die beiden Metall-C-Ringe in einer oberen sowie in einer unteren Nut des Isolierrings fixiert sind.

Durch den Einsatz der C-Ringe ist eine Verpresskraft von 65 N/mm Dichtungsumfang nötig. ZrO₂ hat als Keramikbauteil kein Setzverhalten. Durch die geringe Flächenpressung ist der Isolierring aus Keramik nicht zerbrochen.

Durch die sehr hohe Temperaturbeständigkeit und die deutlich höhere spezifische Wärmeleitfähigkeit gegenüber PTFE war die dem Reaktor zugewandte Seite des Isolierrings nach 12 Monaten Betriebszeit thermisch nicht angegriffen.

Allerdings zeigten die C-Ringe an den Abdichtflächen oberflächliche mechanische Schäden, verursacht durch thermische Ausdehnung wegen großer Temperaturänderungen der Dichtkörper beim An-und Abfahren des Reaktors im Batch betreib der einzelnen Chargen , wobei insbesondere der obere C-Ring stark beschädigt war. Es hat sich gezeigt, dass die Dichtelemente spätestens nach 9 Monaten Betriebszeit ausgetauscht werden müssen.

Die Standzeit erhöhte sich also gegenüber Vergleichsbeispiel 1 auf maximal 9 Monate.

### Beispiel 1

### CVD-Reaktor mit Isolierring aus Zirkonoxid (ZrO2):

Bei dieser Ausführung wird die Dicht- und Isolierfunktion auf zwei Bauteile aufgeteilt. Der Isolierring aus ZrO₂ wird zur elektrischen Isolierung zwischen Elektrodenhalterung und Bodenplatte eingesetzt. Der Isolierring ist 8 mm hoch im Neuzustand. Die Dichtfunktion übernimmt jeweils ein silberbeschichteter Metall-C-Ring zum Kopf der Elektrodenhalterung hin und zur Bodenplatte, wobei ein Metall-C-Ring in einer Nut der Elektrodenhalterung und ein Metall-C-Ring in einer Nut des Isolierrings fixiert sind. Der Überstand c betrug das Zweifache der Höhe des Isolierrings, also 16 mm.

Durch den Einsatz der C-Ringe ist eine Verpresskraft von 65 N/mm Dichtungsumfang nötig. ZrO₂ hat als Keramikbauteil kein Setzverhalten. Durch die geringe Flächenpressung ist der Isolierring aus Keramik nicht zerbrochen.

Durch die sehr hohe Temperaturbeständigkeit und die deutlich höhere spezifische Wärmeleitfähigkeit gegenüber PTFE war die dem Reaktor zugewandte Seite des Isolierrings auch nach 12 Monaten Betriebszeit thermisch nicht angegriffen. Es hat sich gezeigt, dass die Abschattung von Wärmestrahlung infolge des Überstands c dazu beiträgt.

Auch die C-Ringe zeigten nach diesem Zeitraum keine thermische Schäden und kaum mechanische Schäden , wobei der obere, in einer Nut der gekühlten Elektrodenhalterung fixierte C-Ring thermisch und mechanisch nicht angegriffen war.

Die Standzeit erhöhte sich also auf mindestens 12 Monate.

### Beispiel 2

Bei dieser Ausführung wird die Dicht- und Isolierfunktion auf zwei Bauteile aufgeteilt. Der Isolierring aus ZrO₂ wird zur elektrischen Isolierung zwischen Elektrodenhalterung und Bodenplatte eingesetzt. Der Isolierring ist 8 mm hoch im Neuzustand. Die Dichtfunktion übernimmt jeweils ein silberbeschichteter Metall-C-Ring zum Kopf der Elektrodenhalterung hin und zur Bodenplatte, wobei ein Metall-C-Ring in einer Nut der Elektrodenhalterung und ein Metall-C-Ring einer Nut der Bodenplatte fixiert sind. Die Elektrodenhalterung hatte keinen Überstand c in Bezug auf den Isolierring.

Durch die sehr hohe Temperaturbeständigkeit und die deutlich höhere spezifische Wärmeleitfähigkeit gegenüber PTFE war die dem Reaktor zugewandte Seite des Isolierrings nach 12 Monaten Betriebszeit thermisch nicht angegriffen.

Durch die Kühlung von Elektrodenhalterung und Bodenplatte wurden auch die Metall-C-Ringe thermisch und mechanisch nicht angegriffen.

Die Standzeit erhöhte sich somit auf mindestens 12 Monate.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen sowie Äquivalente durch den Schutzbereich der Ansprüche abgedeckt sein.

## Patentansprüche

1. Vorrichtung zur Isolierung und Abdichtung von Elektrodenhalterungen (1) in CVD Reaktoren, umfassend eine zur Aufnahme eines Filamentstabs geeignete Elektrode auf einer gekühlten Elektrodenhalterung (1) aus einem elektrisch leitfähigen Material, die in einer Aussparung einer gekühlten Bodenplatte (3) angebracht ist, wobei zwischen Elektrodenhalterung (1) und Bodenplatte (3) ein elektrisch isolierender Ring (2) aus einem Werkstoff mit einer spezifischen Wärmeleitfähigkeit bei Raumtemperatur von 1 - 200 W/mK, einer Dauertemperaturbeständigkeit von größer oder gleich 400°C und einem spezifischen elektrischen Widerstand bei Raumtemperatur von größer als 10⁹ Ωcm vorgesehen ist, wobei mindestens zwei ringförmige Dichtelemente (4) zur Abdichtung zwischen Elektrodenhalterung (1) und Bodenplatte (3) vorhanden sind, wobei der elektrisch isolierende Ring (2) oder die Elektrodenhalterung (1) oder die Bodenplatte (3) Nuten (9) umfassen, in denen die Dichtelemente (4) fixiert sind, wobei wenigstens eines der Dichtelemente (4) in einer in der Elektrodenhalterung (1) oder in einer in der Bodenplatte (3) angebrachten, oberhalb oder unterhalb des elektrisch isolierende Rings (2) befindlichen Nut (9) fixiert ist.

2. Vorrichtung nach Anspruch 1, wobei der Werkstoff des elektrisch isolierenden Rings (2) ausgewählt wird aus der Gruppe bestehend aus Aluminiumoxid, Siliciumnitrid, Bornitrid, Zirkonoxid und mit Yttriumoxid, mit Magnesiumoxid oder mit Calciumoxid stabilisiertem Zirkonoxid.

3. Vorrichtung nach Anspruch 1 oder nach Anspruch 2, wobei es sich bei den Dichtelementen (4) um O-Ringe aus einem elastomeren Werkstoff handelt.

4. Vorrichtung nach Anspruch 3, wobei die O-Ringe aus Fluorelastomeren, aus Perfluorelastomeren oder aus Silikon-Elastomeren bestehen.

5. Vorrichtung nach Anspruch 1 oder nach Anspruch 2, wobei es sich bei den Dichtelementen (4) um Graphitfolienringe handelt.

6. Vorrichtung nach Anspruch 1 oder nach Anspruch 2, wobei es sich bei den Dichtelementen (4) um metallische O-Ringe oder um metallische Dichtungen mit einem offenen Profil mit Federwirkung handelt.

7. Vorrichtung nach Anspruch 6, wobei die metallischen Dichtungen mit offenem Profil eine innenliegende Spiralfeder umfassen.

8. Vorrichtung nach Anspruch 6 oder nach Anspruch 7, wobei die metallischen Dichtelemente mit einem duktilen Metall beschichtet sind.

9. Vorrichtung nach Anspruch 8, wobei die metallische Dichtung ein C-Profil aufweist und mit Silber beschichtet ist.

10. Vorrichtung nach Anspruch 1 oder nach Anspruch 2, wobei die Dichtelemente (4) mehrere zu Kreisen gefügte Metallbänder mit unterschiedlichem Durchmesser enthalten, wobei die kreisförmigen Metallbänder ineinander gestellt sind und jeweils mindestens einen Knick oder Bogen aufweisen, wobei sich zwischen den einzelnen Metallbändern ein Füllstoff befindet.

11. Vorrichtung nach Anspruch 10, wobei die Metallbänder in Form einer Spirale aufgewickelt sind und es sich bei den Dichtelementen (4) um Spiraldichtungen handelt.

12. Vorrichtung nach Anspruch 10 oder 11, wobei es sich um flexible Metallbänder aus Edelstahl, aus Nickel oder aus einer Nickelbasislegierung handelt.

13. Vorrichtung nach einem der Ansprüche 10 bis 12, wobei es sich bei dem Füllstoff um Graphit handelt.

14. Vorrichtung nach einem der Ansprüche 1 bis 13, wobei ein radialer Überstand c der Elektrodenhalterung (1) gegenüber dem elektrisch isolierenden Ring (2) größer oder gleich 0 und kleiner oder gleich dem achtfachen einer Höhe h des elektrisch isolierenden Rings (2) beträgt.

15. Vorrichtung nach einem der Ansprüche 1 bis 14, wobei die Nuten (9) zur Aufnahme der Dichtelemente (4) am elektrisch isolierenden Ring (2) oder an Bodenplatte (3) oder an Elektrodenhalterung (1) von der Aussparung der Bodenplatte (3) derart beabstandet sind, dass der Abstand von der Aussparung 10-40% einer Gesamtbreite des elektrisch isolierenden Rings (2) beträgt.

16. Verfahren zur Herstellung von polykristallinem Silicium, umfassend Einleiten eines Reaktionsgases enthaltend eine Silicium enthaltende Komponente und Wasserstoff in einen CVD Reaktor enthaltend wenigstens einen Filamentstab, der sich auf einer Vorrichtung gemäß einem der Ansprüche 1 bis 15 befindet, der mittels der Elektrode mit Strom versorgt und der damit durch direkten Stromdurchgang auf eine Temperatur aufgeheizt wird, bei der sich polykristallines Silicium am Filamentstab abscheidet.

## Claims

1. Device for insulating and sealing electrode holders (1) in CVD reactors which comprises an electrode which is suitable for accommodating a filament rod and is disposed on a cooled electrode holder (1) made of an electrically conductive material and mounted in a recess in a cooled floor plate (3), wherein provided between the electrode holder (1) and the floor plate (3) is an electrically insulating ring (2) made of a material of construction having a specific thermal conductivity at room temperature of 1 - 200 W/mK, a sustained use temperature of no less than 400°C and a specific electrical resistance at room temperature of more than 10⁹ Ωcm, wherein at least two ring-shaped sealing elements (4) for sealing between the electrode holder (1) and the floor plate (3) are provided, wherein the electrically insulating ring (2) or the electrode holder (1) or the floor plate (3) comprises grooves (9) in which the sealing elements (4) are secured, wherein at least one of the sealing elements (4) is secured in a groove disposed (9) in the electrode holder (1) or in the floor plate (3) and arranged above or below the electrically insulating ring (2).

2. Device according to Claim 1, wherein the material of construction of the electrically insulating ring (2) is selected from the group consisting of aluminum oxide, silicon nitride, boron nitride, zirconium oxide, and zirconium oxide stabilized with yttrium oxide, with magnesium oxide or with calcium oxide.

3. Device according to Claim 1 or according to Claim 2, wherein the sealing elements (4) are O-rings made of an elastomeric material of construction.

4. Device according to Claim 3, wherein the O-rings are made of fluoroelastomers, of perfluoroelastomers or of silicone elastomers.

5. Device according to Claim 1 or according to Claim 2, wherein the sealing elements (4) are graphite foil rings.

6. Device according to Claim 1 or according to Claim 2, wherein the sealing elements (4) are metallic O-rings or metallic seals having an open profile and a spring action.

7. Device according to Claim 6, wherein the metallic seals having an open profile comprise an internal coil spring.

8. Device according to Claim 6 or according to Claim 7, wherein the metallic sealing elements are coated with a ductile metal.

9. Device according to Claim 8, wherein the metallic seal has a C-profile and is coated with silver.

10. Device according to Claim 1 or according to Claim 2, wherein the sealing elements (4) comprise a plurality of metal bands joined into rings and having different diameters, wherein the ring-shaped metal bands are arranged one inside the other and each have at least one kink or bend, wherein a filler material is disposed between the individual metal bands.

11. Device according to Claim 10, wherein the metal bands are wound up in the shape of a spiral and the sealing elements (4) are spiral seals.

12. Device according to either of Claims 10 and 11, wherein flexible metal bands made of stainless steel, of nickel or of a nickel-based alloy are concerned.

13. Device according to any of Claims 10 to 12, wherein the filler material is graphite.

14. Device according to any of Claims 1 to 13, wherein a radial overlap c of the electrode holder (1) relative to the electrically insulating ring (2) is not less than zero and not more than eight times the height h of the electrically insulating ring (2).

15. Device according to any of Claims 1 to 14, wherein the grooves (9) for receiving the sealing elements (4) in the electrically insulating ring (2) or in the floor plate (3) or in the electrode holder (1) are spaced apart from the recess in the floor plate (3) such that the distance from the recess is 10-40% of the total width of the electrically insulating ring (2).

16. Process for producing polycrystalline silicon, comprising introducing a reaction gas comprising a silicon-comprising component and hydrogen into a CVD reactor comprising at least one filament rod which is disposed on a device according to any of Claims 1 to 15 and which is supplied with current via the electrode and which is thus heated by direct passage of current to a temperature at which polycrystalline silicon is deposited on the filament rod.

## Revendications

1. Dispositif pour l'isolement et l'étanchéification de supports d'électrodes (1) dans des réacteurs de dépôt chimique en phase vapeur (CVD), comprenant une électrode appropriée pour recevoir une tige filamentaire sur un support d'électrode refroidi (1) en un matériau électriquement conducteur, qui est monté dans un évidement d'une plaque de fond refroidie (3), une bague électriquement isolante (2), constituée par un matériau ayant une conductivité thermique spécifique à température ambiante de 1 à 200 W/mK, une résistance à la température durable supérieure ou égale à 400 °C et une résistance électrique spécifique à la température ambiante supérieure à 10⁹ Qcm, étant prévue entre le support d'électrode (1) et la plaque de fond (3), au moins deux éléments d'étanchéité annulaires (4) étant prévus pour assurer l'étanchéité entre le support d'électrode (1) et la plaque de fond (3), la bague électriquement isolante (2) ou le support d'électrode (1) ou la plaque de fond (3) comportant des rainures (9) dans lesquelles les éléments d'étanchéité (4) sont fixés, au moins un des éléments d'étanchéité (4) étant fixé dans une rainure (9) qui se trouve dans le support d'électrode (1) ou dans la plaque de fond (3), au-dessus ou au-dessous de la bague électriquement isolante (2).

2. Dispositif selon la revendication 1, dans lequel le matériau de la bague électriquement isolante (2) est choisi dans le groupe constitué par l'oxyde d'aluminium, le nitrure de silicium, le nitrure de bore, l'oxyde de zirconium et l'oxyde de zirconium stabilisé avec de l'oxyde d'yttrium, avec de l'oxyde de magnésium ou avec de l'oxyde de calcium.

3. Dispositif selon la revendication 1 ou selon la revendication 2, dans lequel les éléments d'étanchéité (4) sont des joints toriques en un matériau élastomère.

4. Dispositif selon la revendication 3, dans lequel les joints toriques sont constitués par des élastomères fluorés, des élastomères perfluorés ou des élastomères de silicone.

5. Dispositif selon la revendication 1 ou selon la revendication 2, dans lequel les éléments d'étanchéité (4) sont des bagues en feuille de graphite.

6. Dispositif selon la revendication 1 ou selon la revendication 2, dans lequel les éléments d'étanchéité (4) sont des joints toriques métalliques ou des joints métalliques ayant un profil ouvert à effet de ressort.

7. Dispositif selon la revendication 6, dans lequel les joints métalliques à profil ouvert comprennent un ressort en spirale intérieur.

8. Dispositif selon la revendication 6 ou selon la revendication 7, dans lequel les éléments d'étanchéité métalliques sont revêtus avec un métal ductile.

9. Dispositif selon la revendication 8, dans lequel le joint métallique présente un profil en C et est revêtu avec de l'argent.

10. Dispositif selon la revendication 1 ou selon la revendication 2, dans lequel les éléments d'étanchéité (4) contiennent plusieurs bandes métalliques assemblées en cercles de diamètres différents, les bandes métalliques circulaires étant disposées les unes dans les autres et comprenant chacune au moins un pli ou un arc, une charge se trouvant entre les bandes métalliques individuelles.

11. Dispositif selon la revendication 10, dans lequel les bandes métalliques sont enroulées sous la forme d'une spirale et les éléments d'étanchéité (4) sont des joints en spirale.

12. Dispositif selon la revendication 10 ou 11, dans lequel il s'agit de bandes métalliques flexibles en acier inoxydable, en nickel ou en un alliage à base de nickel.

13. Dispositif selon l'une quelconque des revendications 10 à 12, dans lequel la charge consiste en du graphite.

14. Dispositif selon l'une quelconque des revendications 1 à 13, dans lequel un dépassement radial c du support d'électrode (1) par rapport à la bague électriquement isolante (2) est supérieur ou égal à 0 et inférieur ou égal à huit fois une hauteur h de la bague électriquement isolante (2).

15. Dispositif selon l'une quelconque des revendications 1 à 14, dans lequel les rainures (9) destinées à recevoir les éléments d'étanchéité (4) sur la bague électriquement isolante (2) ou sur la plaque de fond (3) ou sur le support d'électrode (1) sont espacées de l'évidement de la plaque de fond (3) de telle sorte que l'écart avec l'évidement soit de 10 à 40 % d'une largeur totale de la bague électriquement isolante (2).

16. Procédé de fabrication de silicium polycristallin, comprenant l'introduction d'un gaz réactionnel contenant un composant contenant du silicium et de l'hydrogène dans un réacteur de dépôt chimique en phase vapeur (CVD) contenant au moins une tige filamentaire, qui se trouve sur un dispositif selon l'une quelconque des revendications 1 à 15, qui est alimentée en courant au moyen de l'électrode et qui est ainsi portée par passage de courant direct à une température à laquelle du silicium polycristallin se dépose sur la tige filamentaire.
